(19) Europäisches Patentamt
European Patent Office
Office européen des brevets

(11) **EP 3 306 844 B1**

(12) **EUROPEAN PATENT SPECIFICATION**

(45) Date of publication and mention
of the grant of the patent:
**29.05.2019 Bulletin 2019/22**

(51) Int Cl.:
*H04L 1/00* *(2006.01)*      *H04L 27/34* *(2006.01)*

(21) Application number: **15898502.8**

(86) International application number:
**PCT/CN2015/084374**

(22) Date of filing: **17.07.2015**

(87) International publication number:
**WO 2017/011946 (26.01.2017 Gazette 2017/04)**

(54) **UNEQUAL ERROR PROTECTION-BASED DATA TRANSMISSION METHOD AND APPARATUS**

AUF UNGLEICHEM FEHLERSCHUTZ BASIERENDES DATENÜBERTRAGUNGSVERFAHREN UND VORRICHTUNG

APPAREIL ET PROCÉDÉ DE TRANSMISSION DE DONNÉES BASÉS SUR LA PROTECTION INÉGALE CONTRE LES ERREURS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**11.04.2018 Bulletin 2018/15**

(73) Proprietor: **Huawei Technologies Co., Ltd.
Longgang District
Shenzhen, Guangdong 518129 (CN)**

(72) Inventors:
• **WANG, Hao**
  **Beijing 100876 (CN)**
• **SUN, Haiyun**
  **Beijing 100876 (CN)**
• **LIN, Tongyu**
  **Beijing 100876 (CN)**
• **WANG, Yumei**
  **Beijing 100876 (CN)**
• **TIAN, Chunchang**
  **Shenzhen
  Guangdong 518129 (CN)**

(74) Representative: **Thun, Clemens
Mitscherlich PartmbB
Patent- und Rechtsanwälte
Sonnenstraße 33
80331 München (DE)**

(56) References cited:
**EP-A2- 1 189 380        WO-A2-2008/082277
CN-A- 101 345 738        CN-A- 104 168 083
CN-A- 104 518 846        CN-A- 104 618 068
US-A1- 2005 047 522      US-A1- 2009 219 911
US-A1- 2013 262 963**

• **"3 Generation Partnership Project; Technical Specification Group Radio Access Network; Evolved Universal Terrestrial Radio Access (E-UTRA); Multiplexing and channel coding (Release 12)", 3GPP STANDARD; 3GPP TS 36.212, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, vol. RAN WG1, no. V12.5.0, 24 June 2015 (2015-06-24), pages 1-94, XP050965904, [retrieved on 2015-06-24]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**TECHNICAL FIELD**

Embodiments of the present invention relate to communications technologies, and in particular, to a data transmission method and apparatus based on unequal error protection and a device.

**BACKGROUND**

In addition to a feature of a large data amount, video data has a feature of generating, by means of encoding in a video encoding process, a data stream that affects, in different degrees, a receive end to perform decoding to restore the video data. Therefore, how to perform encoding according to importance of the video data to effectively protect data is a quite important issue.

In the prior art, video data is prioritized according to importance of the video data. After the video data is divided into different queues according to different priorities, the queues are sent to a convolutional encoder, and the convolutional encoder sends the queues to a comb filter. In the comb filter, according to a greedy algorithm, a high-priority data bit is placed into a location of a most significant bit (Most Significant Bit, MSB for short) of a modulation symbol, and a low-priority data bit is placed into a location of a least significant bit (Least Significant Bit, LSB for short) of the modulation symbol. In this way, data can be effectively protected.

For example, EP 1 189 380A2 refers to a method for prioritizing protection in the symbol mapping of selected information including the steps of supplying information bits and overhead bits. Interleaving the information bits and overhead bits to supply a plurality of interleaved data blocks. And selectively mapping the plurality of interleaved data blocks into a modulation symbol.

Further, prior art document ,,3rd Generation Partnership Project; Technical Specification Group Radio Access Network; Evolved Universal Terrestrial Radio Access (E-UTRA), Multiplexing and channel encoding (Release 12), 3GPP TS 36.212, refers to coding, multiplexing and mapping to physical channels for E-UTRA.

However, a channel encoding manner used in the prior art is convolutional code, and before entering an encoder, the video data needs to be divided into different queues according to importance. Turbo encoding is used in a Long Term Evolution (Long Term Evolution, LTE for short) system. In addition, importance of the video data cannot be distinguished. Therefore, an existing video data protection manner is not applicable to the LTE system.

**SUMMARY**

Embodiments of the present invention provide a data transmission method and apparatus based on unequal error protection and a device, so that unequal error protection for video data is implemented in an LTE system.

In a first aspect a data transmission method in a Long Term Evolution, LTE, system based on unequal error protection performed by a base station is provided, the method comprising:

- determining a segment quantity $C$' according to a formula $C' = \dfrac{Q_m}{2} * \left\lceil \dfrac{B}{(Z-L)*Q_m/2} \right\rceil$ wherein Z represents a maximum value of a code block size, B represents a magnitude of an input bit stream corresponding to the code block, L represents a magnitude of a cyclic redundancy check, CRC, parity bit and $Q_m$ is a number of symbol bits in a constellation diagram,
- segmenting the code block according to the segment quantity $C$',

  - turbo encoding the segmented code blocks to obtain encoded code blocks,
  - performing interleaving processing on the encoded code blocks by using an interleaver, to obtain interleaved encoded code blocks,
  - performing rate matching on the interleaved encoded code blocks to obtain output code blocks,
  - using every $Q_m/2$ output code blocks as a code block group, and sorting the output code blocks in each code block group according to importance of the data,
  - for each code block group: separately obtaining one bit from each sorted output code block of the code block group and cascading the obtained bits, and repeating this operation until $Q_m$ bits are cascaded, thereby obtaining cascaded code blocks,
  - sending all cascaded code blocks to a terminal device.

In a second aspect a base station in a Long Term Evolution, LTE, system, is provided wherein the base station is configured to perform the above method.

According to the data transmission method and apparatus based on unequal error protection and the device provided in the embodiments of the present invention, the code block corresponding to the data is segmented according to the quantity of symbol bits in the constellation diagram to obtain the segmented code blocks, rate matching is performed on the segmented code blocks obtained by channel encoding to obtain the output code blocks, the output code blocks are cascaded according to the quantity of symbol bits in the constellation diagram to obtain the cascaded code blocks, and the cascaded code blocks are sent to the terminal device. The base station performs segmentation and cascading processing on the code block according to the quantity of symbol bits in the constellation diagram, so that important data is mapped to a location with a lower bit error rate in the constellation diagram. In this way, a purpose of unequal error protection for data can also be achieved in an LTE system.

## BRIEF DESCRIPTION OF DRAWINGS

To describe the technical solutions in the embodiments of the present invention or in the prior art more clearly, the following briefly describes the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.

FIG. 1 is a schematic architecture diagram of an application scenario of a data transmission method based on unequal error protection according to the present invention;

FIG. 2 is a schematic flowchart of Embodiment 1 of a data transmission method based on unequal error protection according to the present invention;

FIG. 3 is a schematic flowchart of Embodiment 2 of a data transmission method based on unequal error protection according to the present invention;

FIG. 4 is a schematic diagram of a result of code block segmentation;

FIG. 5 shows a rate matching process in an LTE network;

FIG. 6 is a schematic diagram of a code block cascading process;

FIG. 7 is a schematic flowchart of Embodiment 3 of a data transmission method based on unequal error protection according to the present invention;

FIG. 8 is a schematic flowchart of Embodiment 4 of a data transmission method based on unequal error protection according to the present invention;

FIG. 9 is a schematic flowchart of Embodiment 5 of a data transmission method based on unequal error protection according to the present invention;

FIG. 10 is a schematic flowchart of Embodiment 6 of a data transmission method based on unequal error protection according to the present invention;

FIG. 11 is a schematic diagram of segmentation processing;

FIG. 12 is a schematic diagram of interleaving processing;

FIG. 13 is a schematic flowchart of Embodiment 7 of a data transmission method based on unequal error protection according to the present invention;

FIG. 14 is a schematic structural diagram of Embodiment 1 of a data transmission apparatus based on unequal error protection according to the present invention;

FIG. 15 is a schematic structural diagram of Embodiment 2 of a data transmission apparatus based on unequal error protection according to the present invention;

FIG. 16 is a schematic structural diagram of Embodiment 3 of a data transmission apparatus based on unequal error protection according to the present invention;

FIG. 17 is a schematic structural diagram of Embodiment 4 of a data transmission apparatus based on unequal error protection according to the present invention;

FIG. 18 is a schematic structural diagram of Embodiment 5 of a data transmission apparatus based on unequal error protection according to the present invention;

FIG. 19 is a schematic structural diagram of Embodiment 6 of a data transmission apparatus based on unequal error protection according to the present invention;

FIG. 20 is a schematic structural diagram of Embodiment 7 of a data transmission apparatus based on unequal error protection according to the present invention;

FIG. 21 is a schematic structural diagram of Embodiment 8 of a data transmission apparatus based on unequal error protection according to the present invention;

FIG. 22 is a schematic structural diagram of Embodiment 9 of a data transmission apparatus based on unequal error protection according to the present invention;

FIG. 23 is a schematic structural diagram of Embodiment 10 of a data transmission apparatus based on unequal error protection according to the present invention;

FIG. 24 is a schematic structural diagram of Embodiment 1 of a base station according to the present invention;

FIG. 25 is a schematic structural diagram of Embodiment 2 of a base station according to the present invention;

FIG. 26 is a schematic structural diagram of Embodiment 1 of a terminal device according to the present invention; and

FIG. 27 is a schematic structural diagram of Embodiment 2 of a terminal device according to the present invention.

## DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention, which is defined by the appended claims.

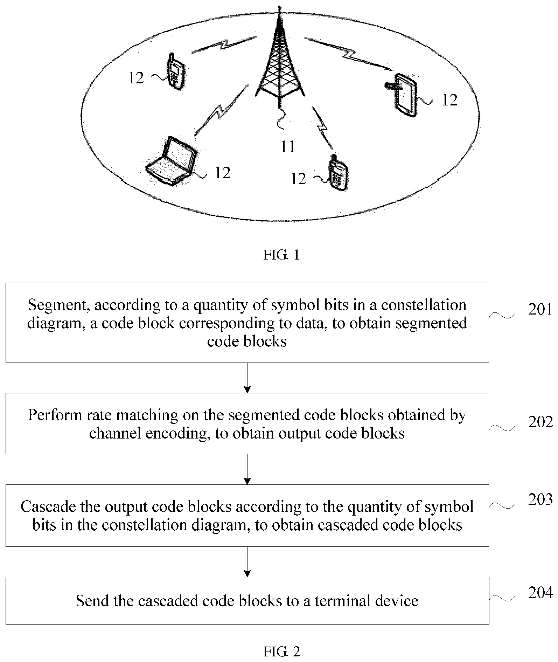

FIG. 1 is a schematic architecture diagram of an application scenario of a data transmission method based on unequal error protection according to the present invention. As shown in FIG. 1, the data transmission method based on unequal error protection is applied to an LTE mobile communications system, and is specifically applied to various video services in the LTE mobile communications system. The system includes a base station 11 and a terminal device 12. The base station 11 is mainly configured to transmit downlink data over a physical downlink shared channel (Physical Downlink Shared Channel, PDSCH for short). The terminal device 12 includes a mobile phone, an intelligent terminal, a multimedia device, a streaming media device, or the like, and is responsible for decoding a received encoding signal, so as to obtain a reconstructed signal that matches the encoding signal.

Detailed descriptions are provided below with reference to several embodiments.

FIG. 2 is a schematic flowchart of Embodiment 1 of a data transmission method based on unequal error protection according to the present invention. This embodiment of the present invention provides a data transmission method based on unequal error protection. The method may be executed by any apparatus that executes the data transmission method based on unequal error protection, and the apparatus may be implemented by using software and/or hardware. In this embodiment, the apparatus may be integrated into a base station.

On the basis of the foregoing system architecture shown in FIG. 1, as shown in FIG. 2, the method in this embodiment may include the following steps.

Step 201: Segment, according to a quantity of symbol bits in a constellation diagram, a code block corresponding to data, to obtain segmented code blocks.

In this embodiment, when the base station receives a message that is sent by a terminal device and that is used to request to receive video data, the base station packs SVC video source data in a unit of byte, that is, performs related processing in a format of a Media Access Control (Media Access Control, MAC for short) protocol data unit (Protocol Data Unit, PDU for short). In a specific implementation process, an L-bit parity bit is first added to a tail of the MAC PDU, to verify whether the MAC PDU is correct. For example, a CRC check manner may be used. A 24-bit parity bit is added to the tail of the MAC PDU. After the parity bit is added, if a length of the MAC PDU is greater than a maximum value 6144 of a code block size, a segment quantity needs to be determined according to the quantity of symbol bits in the constellation diagram, the code block corresponding to the data is segmented according to the segment quantity, and cyclic redundancy check (Cyclic Redundancy Check, CRC for short) redundancy is added to each segmented code block.

Step 202: Perform rate matching on the segmented code blocks obtained by channel encoding, to obtain output code blocks.

In this embodiment, the base station segments the code block, and encodes the segmented code blocks after obtaining the segmented code blocks. In an LTE system, a Turbo encoding manner is usually used. After encoding is performed, system bit code blocks in one channel and parity bit code blocks in two channels are obtained, and interleaving and bit collection processing are separately performed on the code blocks in three channels by using a sub-interleaver, so as to combine the code blocks in three channels into code blocks in one channel. Then, rate matching is performed on the code blocks in one channel to obtain the output code blocks.

Step 203: Cascade the output code blocks according to the quantity of symbol bits in the constellation diagram, to obtain cascaded code blocks.

In this embodiment, the obtained output code blocks are concatenated according to the quantity of symbol bits in the constellation diagram, so that the code blocks are cascaded to obtain the cascaded code blocks.

Step 204: Send the cascaded code blocks to a terminal device.

In this embodiment, the base station sends the cascaded code blocks to the terminal device, so that the terminal device performs code block splitting and decoding processing on the cascaded code blocks to obtain a MAC PDU data packet.

According to the data transmission method based on unequal error protection provided in this embodiment of the present invention, the code block corresponding to the data is segmented according to the quantity of symbol bits in the constellation diagram to obtain the segmented code blocks, rate matching is performed on the segmented code blocks obtained by channel encoding to obtain the output code blocks, the output code blocks are cascaded according to the quantity of symbol bits in the constellation diagram to obtain the cascaded code blocks, and the cascaded code blocks are sent to the terminal device. The base station performs segmentation and cascading processing on the code block according to the quantity of symbol bits in the constellation diagram, so that important data in the data is mapped to a location with a lower bit error rate in the constellation diagram. In this way, a purpose of unequal error protection for data can also be achieved in the LTE system.

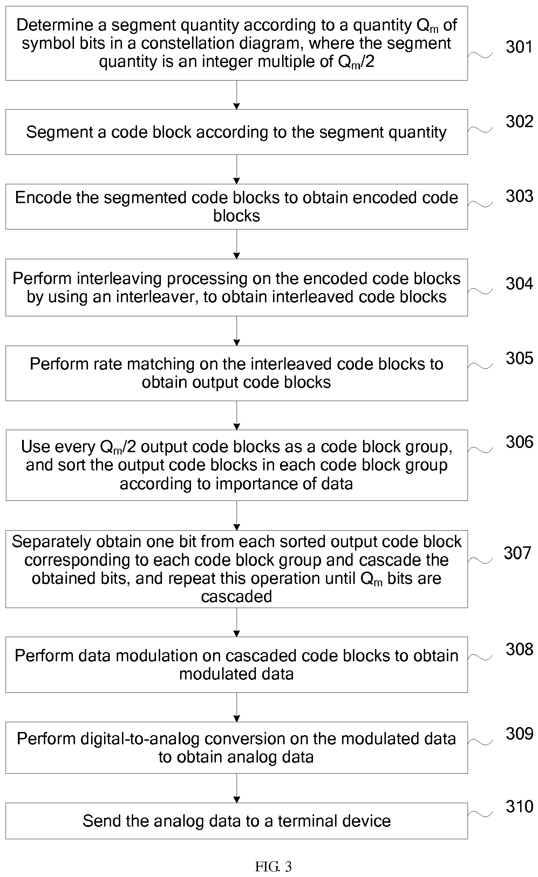

FIG. 3 is a schematic flowchart of Embodiment 2 of a data transmission method based on unequal error protection according to the present invention. On the basis of the embodiment shown in FIG. 2, in this embodiment, manners for segmenting the code block and cascading the output code blocks are described in detail.

On the basis of the foregoing system architecture shown in FIG. 1, as shown in FIG. 3, the method in this embodiment may include the following steps.

Step 301: Determine a segment quantity according to the quantity $Q_m$ of symbol bits in the constellation diagram, where the segment quantity is an integer multiple of $Q_m/2$.

In this embodiment, the segment quantity $C$ is determined according to a formula

$$C = \frac{Q_m}{2} * \left\lceil \frac{B}{(Z-L)*Q_m/2} \right\rceil$$

. $Z$ represents a maximum value of a code block size and is generally 6144. B represents a magnitude of an input bit stream corresponding to the code block. L represents a magnitude of a CRC parity bit. $\lceil \cdot \rceil$ represents rounding up; for example, if a calculated value is 3.5, a result of rounding up is 4. The segment quantity $C$ determined according to the foregoing formula is an integer multiple of $Q_m/2$ The quantity $Q_m$ of symbol bits in the constellation diagram is determined according to a modulation manner selected by an MCS. For example, during 16 quadrature amplitude modulation (Quadrature Amplitude Modulation, QAM for short), $Q_m$ is 4; during 64QAM, $Q_m$ is 6; and during 256QAM, $Q_m$ is 8.

Step 302: Segment the code block according to the segment quantity.

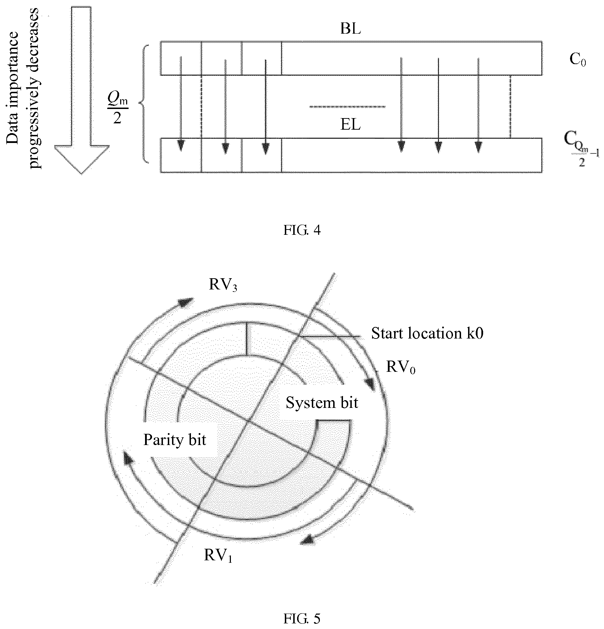

In this embodiment, after the segment quantity is determined, the code block corresponding to the data is segmented according to the segment quantity. By using a manner for determining the segment quantity according to the quantity $Q_m$ of symbol bits in the constellation diagram and segmenting the code block according to the segment quantity, it may be ensured that important data in the code block is mapped to a location of an MSB in the constellation diagram, and unimportant data is mapped to a location of an LSB in the constellation diagram, so that unequal error protection can be performed according to importance of the data. FIG. 4 is a schematic diagram of a result of code block segmentation. As shown in FIG. 4, an SVC encodes a video sequence into a data stream that includes multiple interdependent layers. In an actual video service system, a corresponding quantity of sublayers (sub code streams) are extracted from the stream according to a specific requirement of a user. The most important layer is a base layer (Base layer, BL for short), and other layers are enhancement layers (Enhancement layers, ELs (1 to N)). All ELs need to rely on BL decoding, and a higher EL needs to rely on a lower EL. Therefore, importance of the BL is higher than that of the EL, and importance of a lower EL is higher than that of a higher EL. Generally, for each code block, when the code block is segmented, important data is arranged in a code block with a forward location, and less important data is arranged in a code block with a backward location.

It should be noted that when a quantity of code blocks is greater than 3, the code blocks need to be rearranged. In a specific implementation process, if there are $n*Q_m/2$ blocks, the first $n*Q_m/6$ blocks are separately arranged at $(1+k*Q_m/2)$, the middle $n*Q_m/6$ blocks are separately arranged at $(2+k*Q_m/2)$, and the last $n*Q_m/6$ blocks are separately arranged at $(3+k*Q_m/2)$, where n and k are both integers greater than or equal to zero.

Step 303: Encode the segmented code blocks to obtain encoded code blocks.

In this embodiment, Turbo encoding is performed on the segmented code blocks. Turbo mainly includes parallel cascading convolutional codes, two 8-state sub-encoders, and one Turbo inner-code interleaver. Therefore, a result of Turbo encoding is divided into three channels: The first channel includes system bits, and the last two channels include parity bits. When encoding starts, an initial value of a shift register of the 8-state sub-encoder is 0.

A primary function of the Turbo inner-code interleaver is to combine two mutually independent short codes into one long random code based on an idea of randomization, because performance of a long code can approach the Shannon limit. In addition, the interleaver may be configured to disperse a burst error, and the interleaver may be further configured to break a low-weight input sequence mode, so as to increase a minimum Hamming distance of an output code word or decrease a quantity of low-weight output code words.

Step 304: Perform interleaving processing on the encoded code blocks by using an interleaver, to obtain interleaved code blocks.

In this embodiment, it is assumed that a bit stream that is input into the interleaver is $d_0^{(i)}, d_1^{(i)}, d_2^{(i)}, ..., d_{D-1}^{(i)}$, where D is a quantity of input bits. A quantity of columns of a matrix in the interleaver is $C_{subblock}^{TC} = 32$, and numbers from left to right are successively 0, 1, 2, ..., $C_{subblock}^{TC} - 1$. In addition, to avoid a mistake and improve interleaving correctness, a size of the matrix is required to be greater than or equal to D, that is, $D \leq \left( R_{subblock}^{TC} \times C_{subblock}^{TC} \right)$, where $R_{subblock}^{TC}$ is a quantity of rows of the matrix. Therefore, a value of $R_{subblock}^{TC}$ is a minimum integer value of $D \leq \left( R_{subblock}^{TC} \times C_{subblock}^{TC} \right)$, and numbers of the rows of the matrix from top to bottom are successively 0, 1, 2, ..., $R_{subblock}^{TC} - 1$.

Because $D \leq \left( R_{subblock}^{TC} \times C_{subblock}^{TC} \right)$, the matrix needs to include some padding bits, so as to perform bit padding. Therefore, the matrix includes an information bit and a padding bit. The information bit is a bit corresponding to the data. If $\left( R_{subblock}^{TC} \times C_{subblock}^{TC} \right) > D$, $N_D = \left( R_{subblock}^{TC} \times C_{subblock}^{TC} - D \right)$ dummy bits need to be added to the matrix.

In this embodiment, entering the interleaver in a row-in manner is described. A column-in manner is similar to this, and details are not described herein again. After a quantity of padding bits is determined, a bit sequence $y_{N_D+k} = d_k^{(i)}$ is input into the matrix row by row, where k = 0, 1, ..., D - 1. The first $N_D$ - 1 items in the matrix are added padding bits, and a specific form is as follows:

$$\begin{bmatrix} y_0 & y_1 & y_2 & \cdots & y_{C_{subblock}^{TC}-1} \\ y_{C_{subblock}^{TC}} & y_{C_{subblock}^{TC}+1} & y_{C_{subblock}^{TC}+2} & \cdots & y_{2C_{subblock}^{TC}-1} \\ \vdots & \vdots & \vdots & \ddots & \vdots \\ y_{(R_{subblock}^{TC}-1)\times C_{subblock}^{TC}} & y_{(R_{subblock}^{TC}-1)\times C_{subblock}^{TC}+1} & y_{(R_{subblock}^{TC}-1)\times C_{subblock}^{TC}+2} & \cdots & y_{(R_{subblock}^{TC}\times C_{subblock}^{TC}-1)} \end{bmatrix}$$

Because the result obtained after encoding processing includes data in three channels, correspondingly, three interleavers are required to separately perform interleaving processing on the data in three channels. After the interleaver is entered in the foregoing matrix manner, the three interleavers separately perform corresponding processing on the input matrix.

Specifically, for the system bits in the first channel, an interleaving manner is column permutation. Table 1 shows a column permutation form.

**Table 1**

| Quantity of columns $C_{subblock}^{TC}$ | Column transformation style $< P(0), P(1),..., P(C_{subblock}^{TC}-1) >$ |
|---|---|
| 32 | < 0, 16, 8, 24, 4, 20, 12, 28, 2, 18, 10, 26, 6, 22, 14, 30, 1, 17, 9, 25, 5, 21, 13, 29, 3, 19, 11, 27, 7, 23, 15, 31 > |

As shown in Table 1, P(j) and a number in the second row and the second column in Table 1 are in a one-to-one correspondence. For example, an original first column is permutated into a sixteenth column, and an original second column is permutated into an eighth column. A transformed matrix is:

$$\begin{bmatrix} y_{P(0)} & y_{P(1)} & y_{P(2)} & \cdots & y_{P(C_{subblock}^{TC}-1)} \\ y_{P(0)+C_{subblock}^{TC}} & y_{P(1)+C_{subblock}^{TC}} & y_{P(2)+C_{subblock}^{TC}} & \cdots & y_{P(C_{subblock}^{TC}-1)+C_{subblock}^{TC}} \\ \vdots & \vdots & \vdots & \ddots & \vdots \\ y_{P(0)+(R_{subblock}^{TC}-1)\times C_{subblock}^{TC}} & y_{P(1)+(R_{subblock}^{TC}-1)\times C_{subblock}^{TC}} & y_{P(2)+(R_{subblock}^{TC}-1)\times C_{subblock}^{TC}} & \cdots & y_{P(C_{subblock}^{TC}-1)+(R_{subblock}^{TC}-1)\times C_{subblock}^{TC}} \end{bmatrix}$$

P(j) represents an original column location of $j^{th}$ transformed column. For example, $y_{P(1)}$ in a permutated matrix is corresponding to a bit of $y_{16}$ in the original matrix.

For the parity bits in the second channel, an interleaving manner is a row-in-column-out manner, that is, a bit sequence is read column by column.

For the parity bits in the second channel, output bits may be expressed as $v_0^{(2)}, v_1^{(2)}, v_2^{(2)}, ..., v_{K_\Pi-1}^{(2)}$.

$v_k^{(2)} = y_{\pi(k)}$, where k is an integer greater than or equal to zero, and $\pi(k)$ and $K_\Pi$ may be calculated according to the following formula:

$$\pi(k) = \left( P\left( \left\lfloor \frac{k}{R_{subblock}^{TC}} \right\rfloor \right) + C_{subblock}^{TC} \times \left( k \bmod R_{subblock}^{TC} \right) + 1 \right) \bmod K_\Pi \tag{1}$$

$$K_\Pi = \left( R_{subblock}^{TC} \times C_{subblock}^{TC} \right) \tag{2}$$

Step 305: Perform rate matching on the interleaved code blocks to obtain the output code blocks.

In this embodiment, rate matching is performed in a unit of code block. In this case, it is assumed that an input sequence is $w_{r0} w_{r1}...w_{r(3Tr-1)}$. A buffer size $N_{IR}$ of a single process and a single stream is first calculated according to the following formula:

$$N_{IR} = \left\lfloor \frac{N_{soft}}{K_{MIMO} \cdot \min\left(M_{DL\_HARQ}, M_{\lim it}\right)} \right\rfloor \tag{3}$$

⌊•⌋ represents rounding down; $N_{soft}$ is maximum data cache that can be processed by UE; $K_{MIMO}$ is determined by a quantity of streams and a value is 1 or 2; $M_{DL\_HARQ}$ is a maximum quantity of downlink hybrid automatic repeat request (Hybrid Automatic Repeat reQuest, HARQ for short) processes; $M_{\lim it}$ represents a constant whose value is 8; $\min(MD_{L\_HARQ}, M_{limit})$ is a quantity of HARQ processes.

Then, a buffer size $N_{cb}$ of each code block is calculated according to a formula (4):

$$N_{cb} = \min\left( \left\lfloor \frac{N_{IR}}{C} \right\rfloor, K_w \right) \tag{4}$$

C is a quantity of code blocks, and $K_w$ is a total magnitude of a bit stream from three sub-interleavers.

After the buffer size of each code block is calculated, an output length $E_r$ of each code block after rate matching is performed is calculated according to a formula (5):

$$E_r = \begin{cases} N_L \cdot Q_m \left\lfloor G'/C \right\rfloor, & r \le C-\gamma-1 \\ N_L \cdot Q_m \left\lceil G'/C \right\rceil, & r > C-\gamma-1 \end{cases} \tag{5}$$

$\gamma = G' \bmod C$, $G' = G/(N_L \cdot Q_m)$, r is an integer from 0 to C - 1, and G is a total quantity of bits that can be transmitted according to an allocated available RB resource.

FIG. 5 shows a rate matching process in an LTE network. As shown in FIG. 5, it is assumed that a buffer size of an $r^{th}$ code block is $N_{cb}$, and an output length of rate matching is $E_r$. A version $Rv_0$ is sent for a first time. If a receive end does not perform decoding correctly, an $Rv_{id}$ version is replaced, until the receive end performs decoding correctly.

It should be noted that because a padding bit is padded into the matrix during interleaving processing, when rate matching is performed, if a padding bit is detected, the padding bit is directly skipped, and a next bit is matched. In this way, rate matching is not performed on the padding bit, and bandwidth is effectively saved.

Step 306: Use every $Q_m/2$ output code blocks as a code block group, and sort the output code blocks in each code block group according to importance of the data.

In this embodiment, to ensure that a bit is mapped to a corresponding location of each constellation symbol according to importance of the data, every $Q_m/2$ output code blocks are used as a code block group, and data with progressively decreasing importance is separately placed into one code block group.

Step 307: Separately obtain one bit from each sorted output code block corresponding to each code block group and cascade the obtained bits, and repeat this operation until $Q_m$ bits are cascaded.

In this embodiment, when the code blocks are cascaded, a code block group is used as a unit; and for each code block group, the sorted output code blocks are scanned, and one bit is obtained from each output code block. In this way, each time bit selection is performed, $Q_m/2$ code blocks can be obtained. Because every $Q_m$ bits are corresponding to a symbol in the constellation diagram, selection needs to be consecutively performed twice to obtain $Q_m$ bits. After selection is performed on a code block group, selection is performed on a following code block group. After the bits in each code block are obtained in this manner, when constellation mapping is performed, different data is mapped to a corresponding location according to importance of the data.

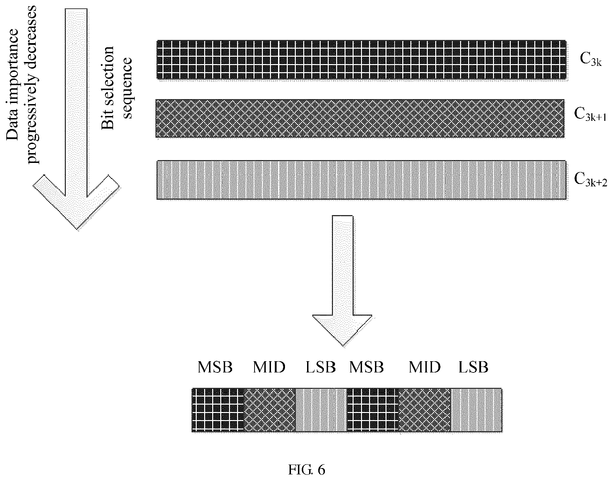

64QAM is used as an example for description. FIG. 6 is a schematic diagram of a code block cascading process. As shown in FIG. 6, when the code block is segmented, according to calculation, a quantity of code blocks is set to be a multiple of 3. Data in a code block $C_{3k}$ is more important than data in a code block $C_{3k+1}$, data in $C_{3k+1}$ is more important than data in $C_{3k+2}$, and $C_{3k}$, $C_{3k+1}$, and $C_{3k+2}$ (k is an integer) form a code block group. When the code blocks are cascaded, one bit is selected from $C_{3k}$, $C_{3k+1}$, and $C_{3k+2}$ (k is an integer) sequentially. When selection is performed twice, one 64QAM symbol is formed. In this way, the selected bits are sequentially mapped to corresponding locations of MSBs, middle bits (Middle bites, MIDs for short), and LSBs in the 64QAM symbol.

Step 308: Perform data modulation on the cascaded code blocks to obtain modulated data.

Step 309: Perform digital-to-analog conversion on the modulated data to obtain analog data.

Step 310: Send the analog data to the terminal device.

According to the data transmission method based on unequal error protection provided in this embodiment of the present invention, the code block corresponding to the data is segmented according to the quantity of symbol bits in the constellation diagram to obtain the segmented code blocks, rate matching is performed on the segmented code blocks obtained by channel encoding to obtain the output code blocks, the output code blocks are cascaded according to the quantity of symbol bits in the constellation diagram to obtain the cascaded code blocks, and the cascaded code blocks are sent to the terminal device. The base station performs segmentation and cascading processing on the code block according to the quantity of symbol bits in the constellation diagram, so that important data in the data is mapped to a location with a lower bit error rate in the constellation diagram. In this way, a purpose of unequal error protection for data can also be achieved in the LTE system. In addition, importance of video data is distinguished according to a code block, so that operability is improved.

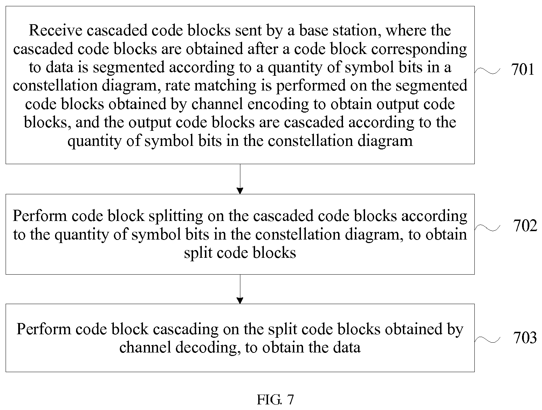

FIG. 7 is a schematic flowchart of Embodiment 3 of a data transmission method based on unequal error protection according to the present invention. This embodiment of the present invention provides a data transmission method based on unequal error protection. The method may be executed by any apparatus that executes the data transmission method based on unequal error protection, and the apparatus may be implemented by using software and/or hardware. In this embodiment, the apparatus may be integrated into a terminal device.

On the basis of the foregoing system architecture shown in FIG. 1, as shown in FIG. 7, the method in this embodiment may include the following steps.

Step 701: Receive cascaded code blocks sent by a base station, where the cascaded code blocks are obtained after a code block corresponding to data is segmented according to a quantity of symbol bits in a constellation diagram, rate matching is performed on the segmented code blocks obtained by channel encoding to obtain output code blocks, and the output code blocks are cascaded according to the quantity of symbol bits in the constellation diagram.

In this embodiment, when the base station receives a message that is sent by the terminal device and that is used to request to receive data, the base station packs SVC video source data in a unit of byte, that is, performs related processing in a format of a Media Access Control (Media Access Control, MAC for short) protocol data unit (Protocol Data Unit, PDU for short). In a specific implementation process, an L-bit parity bit is first added to a tail of the MAC PDU, to verify whether the MAC PDU is correct. For example, a CRC check manner may be used. A 24-bit parity bit is added to the tail of the MAC PDU. After the parity bit is added, if a length of the MAC PDU is greater than a maximum value 6144 of the code block, a segment quantity needs to be determined according to the quantity of symbol bits in the constellation diagram, the code block corresponding to the data is segmented according to the segment quantity, and cyclic redundancy check (Cyclic Redundancy Check, CRC for short) redundancy is added to each segmented code block.

The base station segments the code block, and encodes the segmented code blocks after obtaining the segmented code blocks. In an LTE system, a Turbo encoding manner is usually used. After encoding is performed, system bit code blocks in one channel and parity bit code blocks in two channels are obtained, and interleaving and bit collection processing are separately performed on the code blocks in three channels by using a sub-interleaver, so as to combine the code blocks in three channels into code blocks in one channel. Then, rate matching is performed on the code blocks in one channel to obtain the output code blocks. The base station concatenates the obtained output code blocks according to the quantity of symbol bits in the constellation diagram, so as to cascade the code blocks to obtain the cascaded code blocks, and sends the cascaded code blocks to the terminal device.

Step 702: Perform code block splitting on the cascaded code blocks according to the quantity of symbol bits in the constellation diagram, to obtain split code blocks.

In this embodiment, the base station performs code block cascading according to the quantity of symbol bits in the constellation diagram. Correspondingly, after receiving the cascaded code blocks sent by the base station, the terminal device needs to perform code block splitting according to the quantity of symbol bits in the constellation diagram, to obtain the split code block.

Step 703: Perform code block cascading on the split code blocks obtained by channel decoding, to obtain the data.

In this embodiment, when cascading the decoded split code blocks, the terminal device sequentially concatenates all code blocks, to obtain an output sequence bit, that is, obtain a MAC PDU data packet.

According to the data transmission method based on unequal error protection provided in this embodiment of the present invention, the base station segments, according to the quantity of symbol bits in the constellation diagram, the code block corresponding to the data to obtain the segmented code blocks, performs rate matching on the segmented code blocks obtained by channel encoding to obtain the output code blocks, cascades the output code blocks according to the quantity of symbol bits in the constellation diagram to obtain the cascaded code blocks, and sends the cascaded code blocks to the terminal device. The base station performs segmentation and cascading processing on the code block according to the quantity of symbol bits in the constellation diagram, so that important data in the data is mapped to a location with a lower bit error rate in the constellation diagram. In this way, a purpose of unequal error protection for data can also be achieved in the LTE system. In addition, the terminal device performs code block splitting on the cascaded code blocks according to the quantity of symbol bits in the constellation diagram, to obtain data whose arrangement sequence is the same as that of original data, so that unequal error protection for video data is implemented.

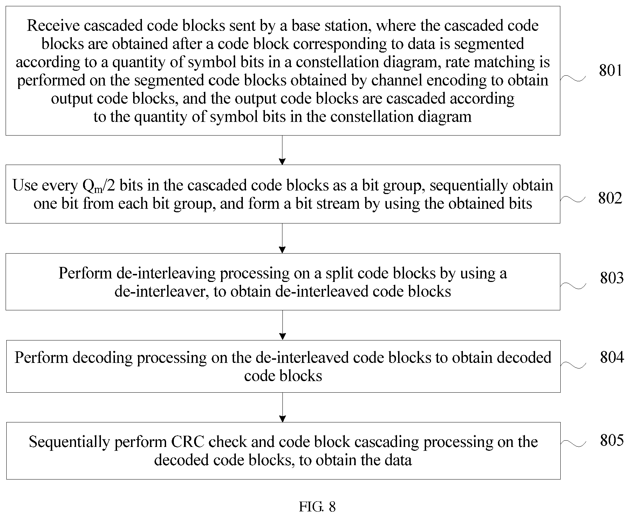

FIG. 8 is a schematic flowchart of Embodiment 4 of a data transmission method based on unequal error protection according to the present invention. On the basis of the embodiment shown in FIG. 7, in this embodiment, a manner for performing code block splitting on the cascaded code blocks is described in detail.

On the basis of the foregoing system architecture shown in FIG. 1, as shown in FIG. 8, the method in this embodiment may include the following steps.

Step 801: Receive the cascaded code blocks sent by the base station, where the cascaded code blocks are obtained after the code block corresponding to the data is segmented according to the quantity of symbol bits in the constellation diagram, rate matching is performed on the segmented code blocks obtained by channel encoding to obtain the output code blocks, and the output code blocks are cascaded according to the quantity of symbol bits in the constellation diagram.

Step 802: Use every $Q_m/2$ bits in the cascaded code blocks as a bit group, sequentially obtain one bit from each bit group, and form a bit stream by using the obtained bits.

In this embodiment, step 802 is an inverse operation of step 306 and step 307. Specifically, received 64QAM symbols are arranged vertically. A second symbol is connected to a previous symbol after being arranged vertically, the rest are arranged sequentially, and finally code blocks are formed by row for outputting. In this way, code block splitting is completed, and data that is on the base station side and that is mapped to a corresponding location in the constellation diagram according to data importance is restored.

Step 803: Perform de-interleaving processing on the split code blocks by using a de-interleaver, to obtain de-interleaved code blocks.

Step 803 is an inverse operation of step 304.

Step 804: Perform decoding processing on the de-interleaved code blocks to obtain decoded code blocks.

Step 804 is an inverse operation of step 303.

Step 805: Sequentially perform CRC check and code block cascading processing on the decoded code blocks, to obtain the data.

In this embodiment, when the code blocks after CRC check are cascaded, the code blocks are sequentially concatenated, to obtain the MAC PDU data packet.

According to the data transmission method based on unequal error protection provided in this embodiment of the present invention, the base station performs segmentation and cascading processing on the code block according to the quantity of symbol bits in the constellation diagram, so that important data in the data is mapped to a location with a lower bit error rate in the constellation diagram. In this way, a purpose of unequal error protection for data can also be achieved in the LTE system. In addition, the terminal device performs, according to the quantity of symbol bits in the constellation diagram, code block splitting on the cascaded code blocks sent by the base station, and performs code block cascading on the obtained split code block. Code blocks mapped to different locations can be split, data is obtained, and scalability of a communications system is improved.

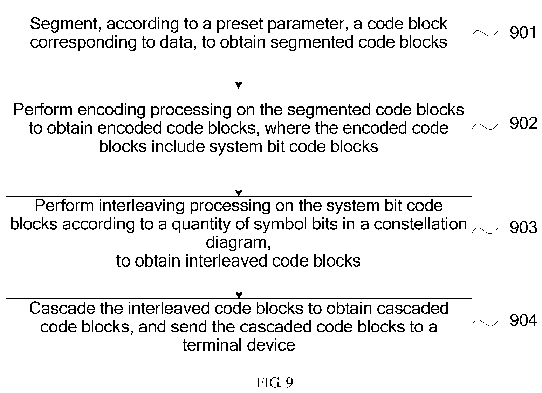

FIG. 9 is a schematic flowchart of Embodiment 5 of a data transmission method based on unequal error protection according to the present invention. This embodiment of the present invention provides a data transmission method based on unequal error protection. The method may be executed by any apparatus that executes the data transmission method based on unequal error protection, and the apparatus may be implemented by using software and/or hardware. In this embodiment, the apparatus may be integrated into a base station.

On the basis of the foregoing system architecture shown in FIG. 1, as shown in FIG. 9, the method in this embodiment may include the following steps.

Step 901: Segment, according to a preset parameter, a code block corresponding to data, to obtain segmented code blocks.

In this embodiment, in 16QAM, a value of $Q_m/2$ is 2; or in 256QAM, a value of $Q_m/2$ is 4. Because a bit stream length $D_r$ that is input into a sub-interleaver is required to be an integer multiple of 2 or 4, when the code block is output from a Turbo encoder, four tail bits need to be added to bits in each channel. That is, $D_r = K_r + 4$, where $K_r$ represents a length of an $r^{th}$ code block when the code block is input into the Turbo encoder, and $D_r$ represents a length of the $r^{th}$ code block when the code block is output from the Turbo encoder. According to an existing protocol, a length of a Turbo code block meets this condition; therefore, a parameter calculation method for code block segmentation is the same as that in the prior art.

However, in 64QAM, to ensure that a sequence of mapping to MSBs, MIDs, and LSBs on a constellation symbol is not affected after the sub-interleaver performs column permutation on the code block, a code block length is required to meet a condition that $(K_r+4)\bmod3 = 0$. Therefore, a segment quantity needs to be determined according to the preset parameter, and the code block corresponding to the data is segmented.

Step 902: Perform encoding processing on the segmented code blocks to obtain encoded code blocks, where the encoded code blocks include system bit code blocks.

Step 902 is similar to step 303, and details are not described herein again.

Step 903: Perform interleaving processing on the system bit code blocks according to a quantity of symbol bits in a constellation diagram, to obtain interleaved code blocks.

In this embodiment, after encoding processing is performed on the segmented code blocks, system bit code blocks and parity bit code blocks in two channels are obtained. For an interleaving processing manner corresponding to the parity bit code blocks in two channels, refer to step 304, and details are not described herein again.

The system bit code blocks may be processed according to the quantity of symbol bits in the constellation diagram, to obtain the interleaved code blocks.

Step 904: Cascade the interleaved code blocks to obtain cascaded code blocks, and send the cascaded code blocks to a terminal device.

In this embodiment, the obtained interleaved code blocks are sequentially concatenated to obtain the cascaded code blocks; data modulation and digital-to-analog conversion are sequentially performed on the cascaded code blocks to obtain analog data; and the analog data is sent to the terminal device, so that the terminal device performs decoding to obtain the data.

According to the data transmission method based on unequal error protection provided in this embodiment of the present invention, the code block corresponding to video data is segmented according to the preset parameter to obtain the segmented code blocks; encoding processing is performed on the segmented code blocks to obtain the encoded code blocks, where the encoded code blocks include the system bit code blocks; interleaving processing is performed on the system bit code blocks according to the quantity of symbol bits in the constellation diagram to obtain the interleaved code blocks; and the interleaved code blocks are cascaded to obtain the cascaded code blocks, and the cascaded code blocks are sent to the terminal device. The base station performs interleaving processing on the system bit code blocks according to the quantity of symbol bits in the constellation diagram, so that important data in the data is mapped to a location with a lower bit error rate in the constellation diagram. In this way, a purpose of unequal error protection for data can also be achieved in an LTE system.

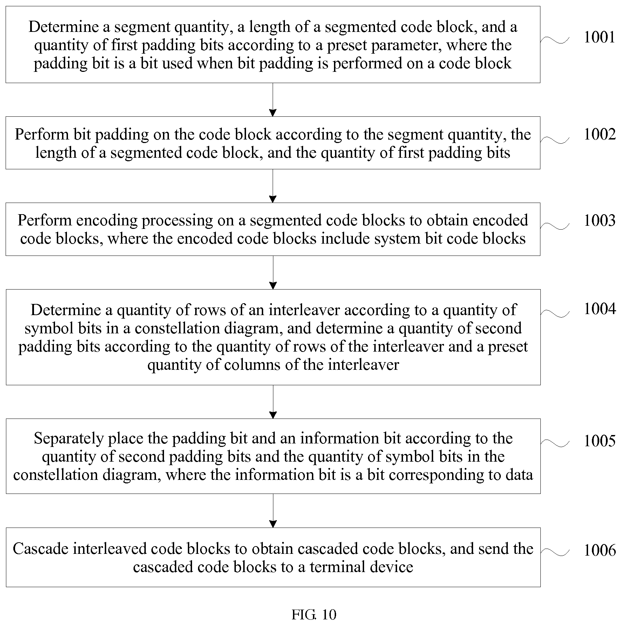

FIG. 10 is a schematic flowchart of Embodiment 6 of a data transmission method based on unequal error protection according to the present invention. On the basis of the embodiment shown in FIG. 9, in this embodiment, manners for segmenting the code block and performing interleaving processing on the system bit code blocks are described in detail.

On the basis of the foregoing system architecture shown in FIG. 1, as shown in FIG. 10, the method in this embodiment may include the following steps.

Step 1001: Determine a segment quantity, a length of a segmented code block, and a quantity of first padding bits according to the preset parameter, where the padding bit is a bit used when bit padding is performed on the code block.

In this embodiment, in 64QAM, the code block length is required to meet the condition that $(K_r+4)\mod 3 = 0$. Therefore, a $K_r$ value that meets this condition in Table 2 needs to be selected to form a new 64QAM code block length table. Table 2 shows an original code block segment length and some Turbo inner-code interleaver parameters, and Table 3 shows a modified code block segment length and some Turbo inner-code interleaver parameters.

**Table 2**

| i | $K_i$ | $f_1$ | $f_2$ | i | $K_i$ | $f_1$ | $f_2$ | i | $K_i$ | $f_1$ | $f_2$ | i | $K_i$ | $f_1$ | $f_2$ |
|---|---|---|---|---|---|---|---|---|---|---|---|---|---|---|---|
| 3 | 56 | 19 | 42 | 48 | 416 | 25 | 52 | 101 | 1184 | 19 | 74 | 142 | 3200 | 111 | 240 |
| 4 | 80 | 11 | 20 | 51 | 440 | 91 | 110 | 106 | 1280 | 199 | 240 | 145 | 3392 | 51 | 212 |
| 7 | 104 | 7 | 26 | 54 | 464 | 247 | 58 | 109 | 1376 | 21 | 86 | 148 | 3584 | 57 | 336 |
| 10 | 128 | 15 | 32 | 57 | 488 | 91 | 122 | 112 | 1472 | 45 | 92 | 151 | 3776 | 179 | 236 |
| 13 | 152 | 9 | 38 | 60 | 512 | 31 | 64 | 115 | 1568 | 13 | 28 | 154 | 3968 | 375 | 248 |
| 16 | 176 | 21 | 44 | 63 | 560 | 227 | 420 | 118 | 1664 | 183 | 104 | 157 | 4160 | 33 | 130 |
| 19 | 200 | 13 | 50 | 66 | 608 | 37 | 76 | 121 | 1760 | 27 | 110 | 160 | 4352 | 477 | 408 |
| 22 | 224 | 27 | 56 | 69 | 656 | 185 | 82 | 124 | 1856 | 57 | 116 | 163 | 4544 | 357 | 142 |

**Table 3**

| i | $K_i$ | $f_1$ | $f_2$ | i | $K_i$ | $f_1$ | $f_2$ | i | $K_i$ | $f_1$ | $f_2$ | i | $K_i$ | $f_1$ | $f_2$ |
|---|---|---|---|---|---|---|---|---|---|---|---|---|---|---|---|
| 3 | 56 | 19 | 42 | 48 | 416 | 25 | 52 | 101 | 1184 | 19 | 74 | 142 | 3200 | 111 | 240 |
| 4 | 80 | 11 | 20 | 51 | 440 | 91 | 110 | 106 | 1280 | 199 | 240 | 145 | 3392 | 51 | 212 |
| 7 | 104 | 7 | 26 | 54 | 464 | 247 | 58 | 109 | 1376 | 21 | 86 | 148 | 3584 | 57 | 336 |
| 10 | 128 | 15 | 32 | 57 | 488 | 91 | 122 | 112 | 1472 | 45 | 92 | 151 | 3776 | 179 | 236 |
| 13 | 152 | 9 | 38 | 60 | 512 | 31 | 64 | 115 | 1568 | 13 | 28 | 154 | 3968 | 375 | 248 |
| 16 | 176 | 21 | 44 | 63 | 560 | 227 | 420 | 118 | 1664 | 183 | 104 | 157 | 4160 | 33 | 130 |
| 19 | 200 | 13 | 50 | 66 | 608 | 37 | 76 | 121 | 1760 | 27 | 110 | 160 | 4352 | 477 | 408 |
| 22 | 224 | 27 | 56 | 69 | 656 | 185 | 82 | 124 | 1856 | 57 | 116 | 163 | 4544 | 357 | 142 |

When a total quantity of code blocks and a code block length are calculated, $C_+$, $C_-$, $K_+$, $K_-$, and F are determined according to an existing method and based on Table 3. $K_+$ and $K_-$ represent the code block length; $C_+$ represents a quantity of code blocks whose code block lengths are $K_+$; $C_-$ represents a quantity of code blocks whose code block lengths are $K_-$; and F is a quantity of padding bits.

Step 1002: Perform bit padding on the code block according to the segment quantity, the length of a segmented code block, and the quantity of first padding bits.

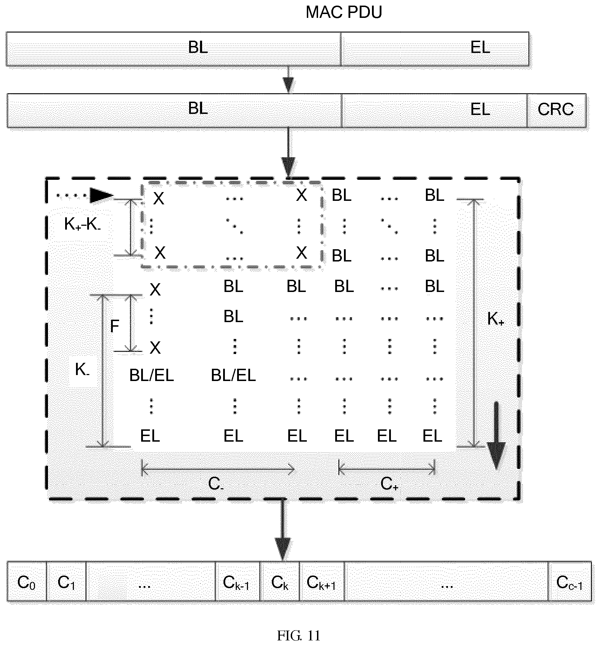

In this embodiment, FIG. 11 is a schematic diagram of segmentation processing. As shown in FIG. 11, after CRC check is performed on a MAC PDU data packet, when segmentation processing is performed, a $K_+$-row-$C$-column interleaver is added to a matrix. A padding bit is placed into a sub-matrix of a $(K_+-K_-)*C_-$ size in an upper left corner of the matrix. F padding bits are then placed into a first column. A MAC PDU sequence is input into the interleaver by column and is output by column. In this way, C code blocks that comply with an arrangement sequence that important data is placed forward are obtained.

Step 1003: Perform encoding processing on the segmented code blocks to obtain the encoded code blocks, where the encoded code blocks include the system bit code blocks.

Step 1004: Determine a quantity of rows of an interleaver according to the quantity of symbol bits in the constellation diagram, and determine a quantity of second padding bits according to the quantity of rows of the interleaver and a preset quantity of columns of the interleaver.

In this embodiment, a quantity of rows of the sub-interleaver is required to be a minimum integer value of

$$R_{subblock}^{TC} * 32 > D \quad \text{and} \quad R_{subblock}^{TC} \bmod \frac{Q_m}{2} = 0,$$ where subblock is the quantity of rows of the sub-interleaver, and D is a quantity of input bits. In addition, the quantity of second padding bits $N_D = R_{subblock}^{TC} * C_{subblock}^{TC} - D$, where

$C_{subblock}^{TC}$ is a quantity of columns of the interleaver, and a value is generally 32.

Step 1005: Separately place the padding bit and an information bit according to the quantity of second padding bits and the quantity of symbol bits in the constellation diagram, where the information bit is a bit corresponding to the data.

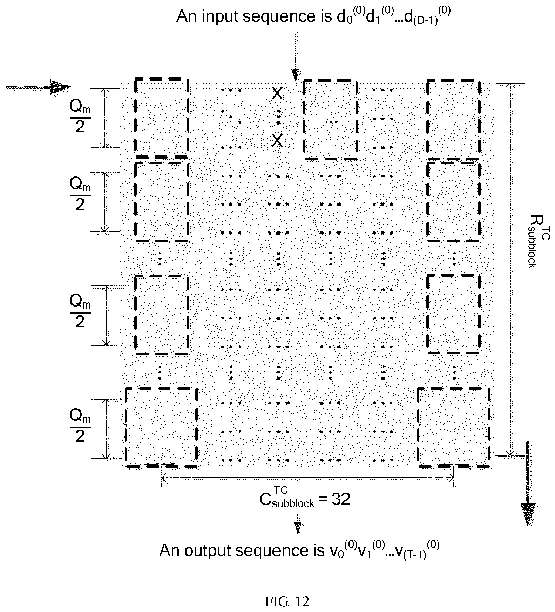

FIG. 12 is a schematic diagram of interleaving processing. As shown in FIG. 12, generally, $N_D < Q_m/2 * C_{subblock}^{TC}$. Therefore, the padding bit X is placed into a sub-matrix of $(Q_m/2)*(2N_D/Q_m)$ in an upper left corner of a matrix. For placement of the information bit, from a first row, one information bit may be placed every $Q_m/2$ rows. After placement is completed, from a second row, the information bit is placed every $Q_m/2$ rows. This operation is cyclically performed until placement is performed from a $Q_m/2_{th}$ row, so that all information bits are placed. It can be learned that code block data is placed every $Q_m/2$ rows, so that most important data is placed into a first row of a column of data of $Q_m/2$ bits, less important data is placed into a middle row, and least important data is placed into a last row. In this way, although column permutation is performed, after a bit stream is read by column, a group of $Q_m/2$ bits can be mapped to corresponding MSBs, MIDs, and LSBs on a constellation symbol.

Step 1006: Cascade the interleaved code blocks to obtain the cascaded code blocks, and send the cascaded code blocks to the terminal device.

According to the data transmission method based on unequal error protection provided in this embodiment of the present invention, the code block corresponding to the data is segmented according to the preset parameter to obtain the segmented code blocks; encoding processing is performed on the segmented code blocks to obtain the encoded code blocks, where the encoded code blocks include the system bit code blocks; interleaving processing is performed on the system bit code blocks according to the quantity of symbol bits in the constellation diagram to obtain the interleaved code blocks; and the interleaved code blocks are cascaded to obtain the cascaded code blocks, and the cascaded code blocks are sent to the terminal device. The base station performs interleaving processing on the system bit code blocks according to the quantity of symbol bits in the constellation diagram, so that important data in the data is mapped to a location with a lower bit error rate in the constellation diagram. In this way, a purpose of unequal error protection for data can also be achieved in the LTE system. In addition, importance of the data is distinguished according to a code block, any modulation manner may be adapted to, and system scalability is improved.

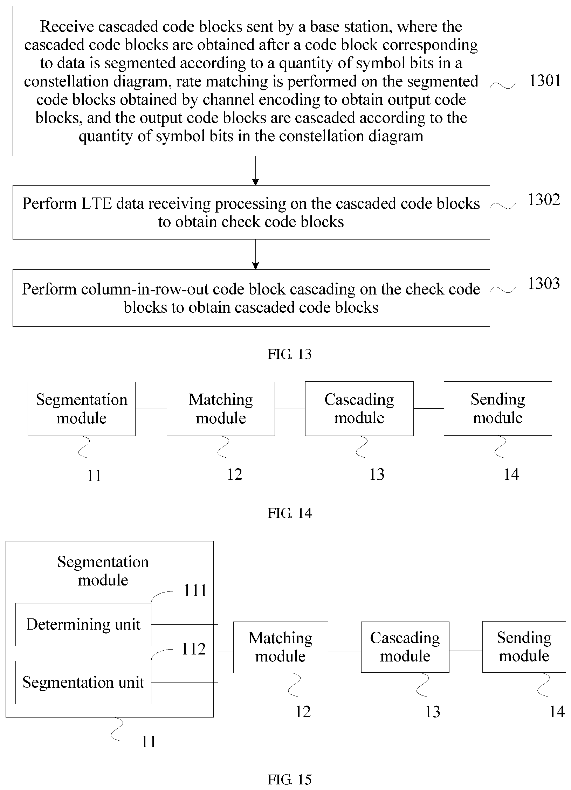

FIG. 13 is a schematic flowchart of Embodiment 7 of a data transmission method based on unequal error protection according to the present invention. This embodiment of the present invention provides a data transmission method based on unequal error protection. The method may be executed by any apparatus that executes the data transmission method based on unequal error protection, and the apparatus may be implemented by using software and/or hardware. In this embodiment, the apparatus may be integrated into a terminal device.

On the basis of the foregoing system architecture shown in FIG. 1, as shown in FIG. 13, the method in this embodiment may include the following steps.

Step 1301: Receive cascaded code blocks sent by a base station, where the cascaded code blocks are obtained after a code block corresponding to data is segmented according to a quantity of symbol bits in a constellation diagram, rate matching is performed on the segmented code blocks obtained by channel encoding to obtain output code blocks, and the output code blocks are cascaded according to the quantity of symbol bits in the constellation diagram.

In this embodiment, to ensure, by the base station, that a sequence of mapping to MSBs, MIDs, and LSBs on a constellation symbol is not affected after a sub-interleaver performs column permutation on the code block, a code block length is required to meet a condition that $(K_r+4)\bmod3 = 0$. Therefore, a segment quantity needs to be determined according to a preset parameter, and the code block corresponding to the data is segmented. After segmenting is completed, the obtained segmented code block is encoded to obtain an encoded code block, where the encoded code blocks include system bit code blocks. Then, interleaving processing is performed on the system bit code blocks according to the quantity of symbol bits in the constellation diagram to obtain interleaved code blocks, the interleaved code blocks are cascaded to obtain the cascaded code blocks, and the cascaded code blocks are sent to the terminal device.

Step 1302: Perform LTE data receiving processing on the cascaded code blocks to obtain check code blocks.

In this embodiment, after the cascaded code blocks sent by the base station are received, code block splitting is performed on the cascaded code block, and de-interleaving processing, decoding processing, and CRC check are sequentially performed on an obtained split code block to obtain the check code blocks.

Step 1303: Perform column-in-row-out code block cascading on the check code blocks to obtain cascaded code blocks.

In this embodiment, the check code blocks are cascaded according to a column-in-row-out principle to form data in a BL + EL form, so that a sequence of cascaded data is consistent with that of original MAC PDU data.

According to the data transmission method based on unequal error protection provided in this embodiment of the present invention, the cascaded code blocks sent by the base station are received, LTE data receiving processing is performed on the cascaded code blocks to obtain the check code blocks, and row-in-column-out code block cascading is performed on the check code blocks to obtain the cascaded code blocks. The base station performs interleaving processing on the system bit code blocks according to the quantity of symbol bits in the constellation diagram, so that important data in the data is mapped to a location with a lower bit error rate in the constellation diagram. In this way, a purpose of unequal error protection for data can also be achieved in an LTE system. In addition, the terminal device performs column-in-row-out code block cascading on the check code block, so that the sequence of the cascaded data is consistent with that of the original MAC PDU data, unequal error protection for video data is implemented, and video quality is improved.

FIG. 14 is a schematic structural diagram of Embodiment 1 of a data transmission apparatus based on unequal error protection according to the present invention. As shown in FIG. 14, the data transmission apparatus based on unequal error protection provided in this embodiment of the present invention includes a segmentation module 11, a matching module 12, a cascading module 13, and a sending module 14.

The segmentation module 11 is configured to segment, according to a quantity of symbol bits in a constellation diagram, a code block corresponding to data, to obtain segmented code blocks. The matching module 12 is configured to perform rate matching on the segmented code blocks obtained by channel encoding, to obtain output code blocks. The cascading module 13 is configured to cascade the output code blocks according to the quantity of symbol bits in the constellation diagram, to obtain cascaded code blocks. The sending module 14 is configured to send the cascaded code blocks to a terminal device.

According to the data transmission apparatus based on unequal error protection provided in this embodiment of the present invention, the code block corresponding to the data is segmented according to the quantity of symbol bits in the constellation diagram to obtain the segmented code blocks, rate matching is performed on the segmented code blocks obtained by channel encoding to obtain the output code blocks, the output code blocks are cascaded according to the quantity of symbol bits in the constellation diagram to obtain the cascaded code blocks, and the cascaded code blocks are sent to the terminal device. A base station performs segmentation and cascading processing on the code block according to the quantity of symbol bits in the constellation diagram, so that important data in the data is mapped to a location with a lower bit error rate in the constellation diagram. In this way, a purpose of unequal error protection for data can also be achieved in an LTE system.

FIG. 15 is a schematic structural diagram of Embodiment 2 of a data transmission apparatus based on unequal error protection according to the present invention. As shown in FTG. 15, on the basis of the embodiment shown in FIG. 14, in this embodiment, the segmentation module 11 includes:

a determining unit 111, configured to determine a segment quantity according to the quantity $Q_m$ of symbol bits in the constellation diagram, where the segment quantity is an integer multiple of $Q_m/2$; and
a segmentation unit 112, configured to segment the code block according to the segment quantity.

Optionally, the determining unit 111 is specifically configured to:

determine the segment quantity $C'$ according to a formula $C' = \dfrac{Q_m}{2} * \left\lceil \dfrac{B}{(Z-L) * Q_m / 2} \right\rceil$ where Z represents a maximum value of a code block size, B represents a magnitude of an input bit stream corresponding to the code block, and L represents a magnitude of a CRC parity bit.

The data transmission apparatus based on unequal error protection in this embodiment may be configured to execute the technical solution of the data transmission method based on unequal error protection provided in any embodiment of the present invention. An implementation principle and a technical effect of the data transmission apparatus are similar to those of the data transmission method, and details are not described herein again.

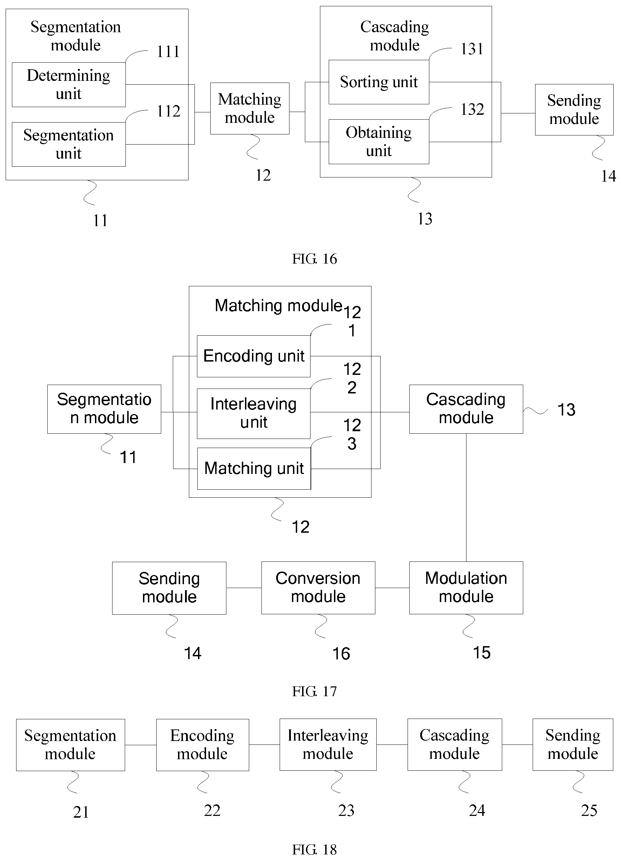

FIG. 16 is a schematic structural diagram of Embodiment 3 of a data transmission apparatus based on unequal error protection according to the present invention. As shown in FIG. 16, on the basis of the embodiment shown in FIG. 15, in this embodiment, the cascading module 13 includes:

a sorting unit 131, configured to use every $Q_m/2$ output code blocks as a code block group, and sort the output code blocks in each code block group according to importance of the data; and

an obtaining unit 132, configured to separately obtain one bit from each sorted output code block corresponding to each code block group and cascade the obtained bits, and repeat this operation until $Q_m$ bits are cascaded.

The data transmission apparatus based on unequal error protection in this embodiment may be configured to execute the technical solution of the data transmission method based on unequal error protection provided in any embodiment of the present invention. An implementation principle and a technical effect of the data transmission apparatus are similar to those of the data transmission method, and details are not described herein again.

FIG. 17 is a schematic structural diagram of Embodiment 4 of a data transmission apparatus based on unequal error protection according to the present invention. As shown in FTG. 17, on the basis of the foregoing embodiments, in this embodiment, the matching module 12 includes:

an encoding unit 121, configured to encode the segmented code blocks to obtain encoded code blocks;
an interleaving unit 122, configured to perform interleaving processing on the encoded code blocks by using an interleaver, to obtain interleaved code blocks; and
a matching unit 123, configured to perform rate matching on the interleaved code blocks to obtain the output code blocks.

Optionally, the apparatus further includes:

a modulation module 15, configured to perform data modulation on the cascaded code blocks to obtain modulated data; and
a conversion module 16, configured to perform digital-to-analog conversion on the modulated data to obtain analog data; where
the sending module 14 is further configured to send the analog data to the terminal device.

The data transmission apparatus based on unequal error protection in this embodiment may be configured to execute the technical solution of the data transmission method based on unequal error protection provided in any embodiment of the present invention. An implementation principle and a technical effect of the data transmission apparatus are similar to those of the data transmission method, and details are not described herein again.

FIG. 18 is a schematic structural diagram of Embodiment 5 of a data transmission apparatus based on unequal error protection according to the present invention. As shown in FIG. 18, the data transmission apparatus based on unequal error protection provided in this embodiment of the present invention includes a segmentation module 21, an encoding module 22, an interleaving module 23, a cascading module 24, and a sending module 25.

The segmentation module 21 is configured to segment, according to a preset parameter, a code block corresponding to data, to obtain segmented code blocks.

The encoding module 22 is configured to perform encoding processing on the segmented code blocks to obtain encoded code blocks, where the encoded code blocks include system bit code blocks.

The interleaving module 23 is configured to perform interleaving processing on the system bit code blocks according to a quantity of symbol bits in a constellation diagram, to obtain interleaved code blocks.

The cascading module 24 is configured to cascade the interleaved code blocks to obtain cascaded code blocks.

The sending module 25 is configured to send the cascaded code blocks to a terminal device.

According to the data transmission apparatus based on unequal error protection provided in this embodiment of the present invention, the code block corresponding to the data is segmented according to the preset parameter to obtain the segmented code blocks; encoding processing is performed on the segmented code blocks to obtain the encoded code blocks, where the encoded code blocks include the system bit code blocks; interleaving processing is performed on the system bit code blocks according to the quantity of symbol bits in the constellation diagram to obtain the interleaved code blocks; and the interleaved code blocks are cascaded to obtain the cascaded code blocks, and the cascaded code blocks are sent to the terminal device. A base station performs interleaving processing on the system bit code blocks according to the quantity of symbol bits in the constellation diagram, so that important data in the data is mapped to a location with a lower bit error rate in the constellation diagram. In this way, a purpose of unequal error protection for data can also be achieved in an LTE system.

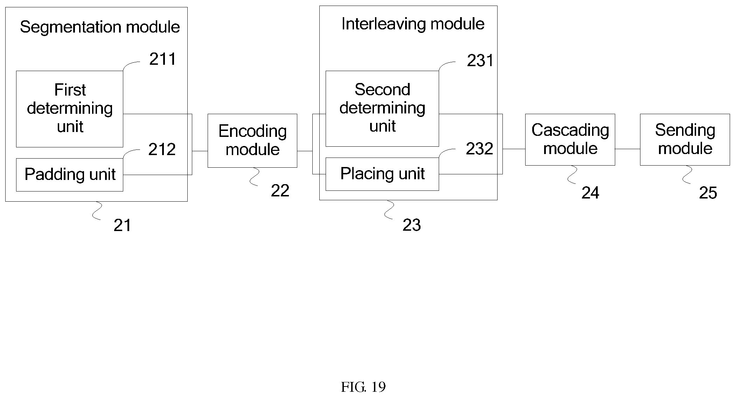

FIG. 19 is a schematic structural diagram of Embodiment 6 of a data transmission apparatus based on unequal error protection according to the present invention. As shown in FIG. 19, on the basis of the embodiment shown in FIG. 18, in this embodiment, the segmentation module 21 includes:

a first determining unit 211, configured to determine a segment quantity, a length of a segmented code block, and a quantity of first padding bits according to the preset parameter, where the padding bit is a bit used when bit padding is performed on the code block; and

a padding unit 212, configured to perform bit padding on the code block according to the segment quantity, the length of a segmented code block, and the quantity of first padding bits, so as to segment the code block.

Optionally, the interleaving module 23 includes:

a second determining unit 231, configured to determine a quantity of rows of an interleaver according to the quantity of symbol bits in the constellation diagram, and determine a quantity of second padding bits according to the quantity of rows of the interleaver and a preset quantity of columns of the interleaver; and
a placing unit 232, configured to separately place the padding bit and an information bit according to the quantity of second padding bits and the quantity of symbol bits in the constellation diagram, where the information bit is a bit corresponding to the data.

The data transmission apparatus based on unequal error protection in this embodiment may be configured to execute the technical solution of the data transmission method based on unequal error protection provided in any embodiment of the present invention. An implementation principle and a technical effect of the data transmission apparatus are similar to those of the data transmission method, and details are not described herein again.

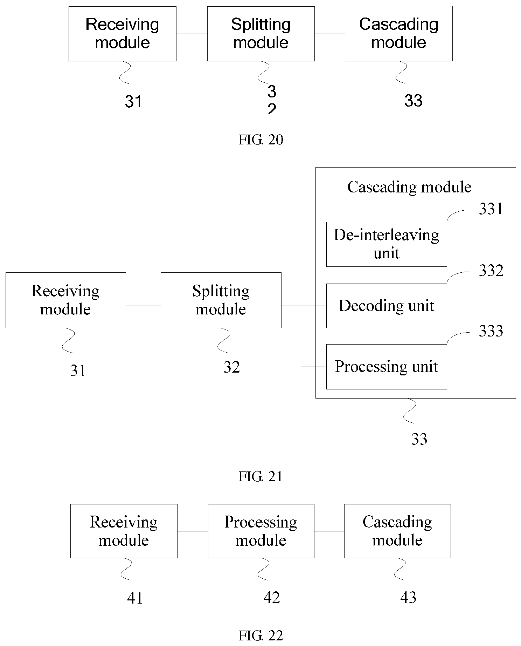

FIG. 20 is a schematic structural diagram of Embodiment 7 of a data transmission apparatus based on unequal error protection according to the present invention. As shown in FIG. 20, the data transmission apparatus based on unequal error protection provided in this embodiment of the present invention includes a receiving module 31, a splitting module 32, and a cascading module 33.

The receiving module 31 is configured to receive cascaded code blocks sent by a base station, where the cascaded code blocks are obtained after a code block corresponding to data is segmented according to a quantity of symbol bits in a constellation diagram, rate matching is performed on the segmented code blocks obtained by channel encoding to obtain output code blocks, and the output code blocks are cascaded according to the quantity of symbol bits in the constellation diagram. The splitting module 32 is configured to perform code block splitting on the cascaded code blocks according to the quantity of symbol bits in the constellation diagram, to obtain split code blocks. The cascading module 33 is configured to perform code block cascading on the split code blocks obtained by channel decoding, to obtain the data.

According to the data transmission apparatus based on unequal error protection provided in this embodiment of the present invention, the base station segments, according to the quantity of symbol bits in the constellation diagram, the code block corresponding to the data to obtain the segmented code blocks, performs rate matching on the segmented code blocks obtained by channel encoding to obtain the output code blocks, cascades the output code blocks according to the quantity of symbol bits in the constellation diagram to obtain the cascaded code blocks, and sends the cascaded code blocks to the terminal device. The base station performs segmentation and cascading processing on the code block according to the quantity of symbol bits in the constellation diagram, so that important data in the data is mapped to a location with a lower bit error rate in the constellation diagram. In this way, a purpose of unequal error protection for data can also be achieved in an LTE system. In addition, the terminal device performs code block splitting on the cascaded code blocks according to the quantity of symbol bits in the constellation diagram, to obtain data whose arrangement sequence is the same as that of original data, so that unequal error protection for data is implemented.

Optionally, the splitting module 32 is specifically configured to use every $Q_m/2$ bits in the cascaded code blocks as a bit group, sequentially obtain one bit from each bit group, and form a bit stream by using the obtained bits.

FIG. 21 is a schematic structural diagram of Embodiment 8 of a data transmission apparatus based on unequal error protection according to the present invention. As shown in FTG. 21, on the basis of the foregoing embodiments, in this embodiment, the cascading module 33 includes:

a de-interleaving unit 331, configured to perform de-interleaving processing on the split code blocks by using a de-interleaver, to obtain de-interleaved code blocks;
a decoding unit 332, configured to perform decoding processing on the de-interleaved code blocks to obtain decoded code blocks; and
a processing unit 333, configured to sequentially perform CRC check and code block cascading processing on the decoded code blocks, to obtain the data.

The data transmission apparatus based on unequal error protection in this embodiment may be configured to execute the technical solution of the data transmission method based on unequal error protection provided in any embodiment of the present invention. An implementation principle and a technical effect of the data transmission apparatus are similar to those of the data transmission method, and details are not described herein again.

FIG. 22 is a schematic structural diagram of Embodiment 9 of a data transmission apparatus based on unequal error protection according to the present invention. As shown in FIG. 22, the data transmission apparatus based on unequal error protection provided in this embodiment of the present invention includes a receiving module 41, a processing module 42, and a cascading module 43.

The receiving module 41 is configured to receive cascaded code blocks sent by a base station, where the cascaded code blocks are obtained after a code block corresponding to data is segmented according to a preset parameter, encoding processing is performed on the obtained segmented code blocks to obtain encoded code blocks, where the encoded code blocks include system bit code blocks, interleaving processing is performed on the system bit code blocks according to a quantity of symbol bits in a constellation diagram to obtain interleaved code blocks, and the interleaved code blocks are cascaded. The processing module 42 is configured to perform LTE data receiving processing on the cascaded code blocks to obtain check code blocks. The cascading module 43 is configured to perform row-in-column-out code block cascading on the check code blocks to obtain cascaded code blocks.

According to the data transmission apparatus based on unequal error protection provided in this embodiment of the present invention, the cascaded code blocks sent by the base station are received, LTE data receiving processing is performed on the cascaded code blocks to obtain the check code blocks, and row-in-column-out code block cascading is performed on the check code blocks to obtain the cascaded code blocks. The base station performs interleaving processing on the system bit code blocks according to the quantity of symbol bits in the constellation diagram, so that important data in the data is mapped to a location with a lower bit error rate in the constellation diagram. In this way, a purpose of unequal error protection for data can also be achieved in an LTE system.

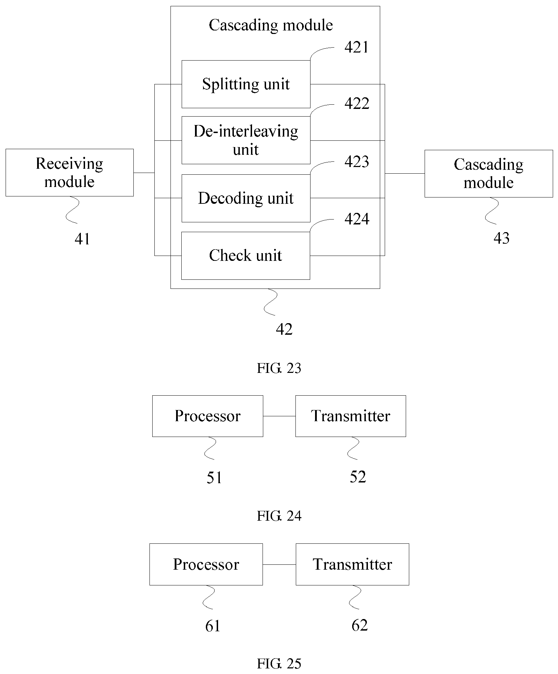

FIG. 23 is a schematic structural diagram of Embodiment 10 of a data transmission apparatus based on unequal error protection according to the present invention. As shown in FIG. 23, on the basis of the embodiment shown in FIG. 22, in this embodiment, the processing module 42 includes:

a splitting unit 421, configured to perform code block splitting on the cascaded code blocks to obtain split code blocks;
a de-interleaving unit 422, configured to perform de-interleaving processing on the split code blocks to obtain de-interleaved code blocks;
a decoding unit 423, configured to perform decoding processing on the de-interleaved code blocks to obtain decoded code blocks; and
a check unit 424, configured to check the decoded code blocks to obtain the check code blocks.

The data transmission apparatus based on unequal error protection in this embodiment may be configured to execute the technical solution of the data transmission method based on unequal error protection provided in any embodiment of the present invention. An implementation principle and a technical effect of the data transmission apparatus are similar to those of the data transmission method, and details are not described herein again.

FIG. 24 is a schematic structural diagram of Embodiment 1 of a base station according to the present invention. As shown in FIG. 24, the base station provided in this embodiment of the present invention includes a processor 51 and a transmitter 52.

The processor 51 is configured to segment, according to a quantity of symbol bits in a constellation diagram, a code block corresponding to data, to obtain segmented code blocks.

The processor 51 is further configured to perform rate matching on the segmented code blocks obtained by channel encoding, to obtain output code blocks.

The processor 51 is further configured to cascade the output code blocks according to the quantity of symbol bits in the constellation diagram, to obtain cascaded code blocks.

The transmitter 52 is configured to send the cascaded code blocks to a terminal device.

The base station provided in this embodiment may be configured to execute the technical solution of the data transmission method based on unequal error protection provided in any embodiment of the present invention. An implementation principle and a technical effect of the base station are similar to those of the data transmission method, and details are not described herein again.

Optionally, the processor 51 is further configured to determine a segment quantity according to the quantity $Q_m$ of symbol bits in the constellation diagram, where the segment quantity is an integer multiple of $Q_m/2$.

The processor 51 is further configured to segment the code block according to the segment quantity.

Optionally, the processor 51 is further configured to determine the segment quantity $C'$ according to a formula

$$C' = \frac{Q_m}{2} * \left\lceil \frac{B}{(Z-L) * Q_m / 2} \right\rceil$$

where Z represents a maximum value of a code block size, B represents a magnitude of an input bit stream corresponding to the code block, and L represents a magnitude of a CRC parity bit.

Optionally, the processor 51 is further configured to use every $Q_m/2$ output code blocks as a code block group, and sort the output code blocks in each code block group according to importance of the data.

The processor 51 is further configured to separately obtain one bit from each sorted output code block corresponding to each code block group and cascade the obtained bits, and repeat this operation until $Q_m$ bits are cascaded.

Optionally, the processor 51 is further configured to encode the segmented code blocks to obtain encoded code blocks.

The processor 51 is further configured to perform interleaving processing on the encoded code blocks by using an interleaver, to obtain interleaved code blocks.

The processor 51 is further configured to perform rate matching on the interleaved code blocks to obtain the output code blocks.

Optionally, the processor 51 is further configured to perform data modulation on the cascaded code blocks to obtain modulated data.

The processor 51 is further configured to perform digital-to-analog conversion on the modulated data to obtain analog data.

The transmitter 52 is further configured to send the analog data to the terminal device.

The base station provided in this embodiment may be configured to execute the technical solution of the data transmission method based on unequal error protection provided in any embodiment of the present invention. An implementation principle and a technical effect of the base station are similar to those of the data transmission method, and details are not described herein again.

FIG. 25 is a schematic structural diagram of Embodiment 2 of a base station according to the present invention. As shown in FIG. 25, the base station provided in this embodiment of the present invention includes a processor 61 and a transmitter 62.

The processor 61 is configured to segment, according to a preset parameter, a code block corresponding to data, to obtain segmented code blocks.

The processor 61 is further configured to perform encoding processing on the segmented code blocks to obtain encoded code blocks, where the encoded code blocks include system bit code blocks.

The processor 61 is further configured to perform interleaving processing on the system bit code blocks according to a quantity of symbol bits in a constellation diagram, to obtain interleaved code blocks.

The processor 61 is further configured to cascade the interleaved code blocks to obtain cascaded code blocks.

The transmitter 62 is configured to send the cascaded code blocks to a terminal device.

The base station provided in this embodiment may be configured to execute the technical solution of the data transmission method based on unequal error protection provided in any embodiment of the present invention. An implementation principle and a technical effect of the base station are similar to those of the data transmission method, and details are not described herein again.

Optionally, the processor 61 is further configured to determine a segment quantity, a length of a segmented code block, and a quantity of first padding bits according to the preset parameter, where the padding bit is a bit used when bit padding is performed on the code block.

The processor 61 is further configured to perform bit padding on the code block according to the segment quantity, the length of a segmented code block, and the quantity of first padding bits, so as to segment the code block.

Optionally, the processor 61 is further configured to determine a quantity of rows of an interleaver according to the quantity of symbol bits in the constellation diagram, and determine a quantity of second padding bits according to the quantity of rows of the interleaver and a preset quantity of columns of the interleaver.

The processor 61 is further configured to separately place the padding bit and an information bit according to the quantity of second padding bits and the quantity of symbol bits in the constellation diagram, where the information bit is a bit corresponding to the data.

The base station provided in this embodiment may be configured to execute the technical solution of the data transmission method based on unequal error protection provided in any embodiment of the present invention. An implementation principle and a technical effect of the base station are similar to those of the data transmission method, and details are not described herein again.

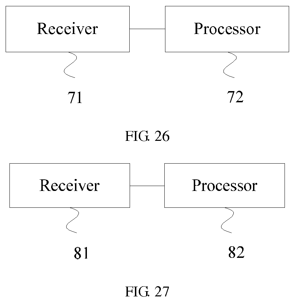

FIG. 26 is a schematic structural diagram of Embodiment 1 of a terminal device according to the present invention. As shown in FIG. 26, the terminal device provided in this embodiment of the present invention includes a receiver 71 and a processor 72.

The receiver 71 is configured to receive cascaded code blocks sent by a base station, where the cascaded code blocks are obtained after a code block corresponding to data is segmented according to a quantity of symbol bits in a constellation diagram, rate matching is performed on the segmented code blocks obtained by channel encoding to obtain output code blocks, and the output code blocks are cascaded according to the quantity of symbol bits in the constellation diagram.

The processor 72 is configured to perform code block splitting on the cascaded code blocks according to the quantity of symbol bits in the constellation diagram, to obtain split code blocks.

The processor 72 is further configured to perform code block cascading on the split code blocks obtained by channel decoding, to obtain the data.

The terminal device provided in this embodiment may be configured to execute the technical solution of the data transmission method based on unequal error protection provided in any embodiment of the present invention. An implementation principle and a technical effect of the terminal device are similar to those of the data transmission method, and details are not described herein again.

Optionally, the processor 72 is further configured to use every $Q_m/2$ bits in the cascaded code blocks as a bit group, sequentially obtain one bit from each bit group, and form a bit stream by using the obtained bits.

Optionally, the processor 72 is further configured to perform de-interleaving processing on the split code blocks by using a de-interleaver, to obtain de-interleaved code blocks.

The processor 72 is further configured to perform decoding processing on the de-interleaved code blocks to obtain decoded code blocks.

The processor 72 is further configured to sequentially perform CRC check and code block cascading processing on the decoded code blocks, to obtain the data.

The terminal device provided in this embodiment may be configured to execute the technical solution of the data transmission method based on unequal error protection provided in any embodiment of the present invention. An implementation principle and a technical effect of the terminal device are similar to those of the data transmission method, and details are not described herein again.

FIG. 27 is a schematic structural diagram of Embodiment 2 of a terminal device according to the present invention. As shown in FIG. 27, the terminal device provided in this embodiment of the present invention includes a receiver 81 and a processor 82.

The receiver 81 is configured to receive cascaded code blocks sent by a base station, where the cascaded code blocks are obtained after a code block corresponding to data is segmented according to a preset parameter, encoding processing is performed on the obtained segmented code blocks to obtain encoded code blocks, where the encoded code blocks include system bit code blocks, interleaving processing is performed on the system bit code blocks according to a quantity of symbol bits in a constellation diagram to obtain interleaved code blocks, and the interleaved code blocks are cascaded.

The processor 82 is configured to perform LTE data receiving processing on the cascaded code blocks to obtain check code blocks.

The processor 82 is further configured to perform row-in-column-out code block cascading on the check code blocks to obtain cascaded code blocks.

The terminal device provided in this embodiment may be configured to execute the technical solution of the data transmission method based on unequal error protection provided in any embodiment of the present invention. An implementation principle and a technical effect of the terminal device are similar to those of the data transmission method, and details are not described herein again.

Optionally, the processor 82 is further configured to perform code block splitting on the cascaded code blocks to obtain split code blocks.

The processor 82 is further configured to perform de-interleaving processing on the split code blocks to obtain de-interleaved code blocks.

The processor 82 is further configured to perform decoding processing on the de-interleaved code blocks to obtain decoded code blocks.

The processor 82 is further configured to check the decoded code blocks to obtain the check code blocks.

The terminal device provided in this embodiment may be configured to execute the technical solution of the data transmission method based on unequal error protection provided in any embodiment of the present invention. An implementation principle and a technical effect of the terminal device are similar to those of the data transmission method, and details are not described herein again.

It may be clearly understood by a person skilled in the art that, for the purpose of convenient and brief description, division of the foregoing function modules is taken as an example for illustration. In actual application, the foregoing functions can be allocated to different function modules and implemented according to a requirement, that is, an inner structure of an apparatus is divided into different function modules to implement all or some of the functions described above. For a detailed working process of the foregoing system, apparatus, and unit, reference may be made to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, the module or unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected according to actual requirements to achieve the objectives of the solutions of the embodiments.

In addition, functional units in the embodiments of this application may be integrated into one processing unit, or each of the units may exist alone physically, or two or more units are integrated into one unit. The integrated unit may be implemented in a form of hardware, or may be implemented in a form of a software functional unit.

When the integrated unit is implemented in the form of a software functional unit and sold or used as an independent product, the integrated unit may be stored in a computer-readable storage medium. Based on such an understanding, the technical solutions of this application essentially, or the part contributing to the prior art, or all or a part of the technical solutions may be implemented in the form of a software product. The software product is stored in a storage medium and includes several instructions for instructing a computer device (which may be a personal computer, a server, or a network device) or a processor (processor) to perform all or a part of the steps of the methods described in the embodiments of this application. The foregoing storage medium includes: any medium that can store program code, such as a USB flash drive, a removable hard disk, a read-only memory (ROM, Read-Only Memory), a random access memory (RAM, Random Access Memory), a magnetic disk, or an optical disc.

The foregoing embodiments are merely intended for describing the technical solutions of this application, but not for limiting this application. Although this application is described in detail with reference to the foregoing embodiments, a person of ordinary skill in the art should understand that they may still make modifications to the technical solutions described in the foregoing embodiments or make equivalent replacements to some technical features thereof, without departing from the scope of the technical solutions of the embodiments of this application. The scope of the invention is defined by the appended claims.

## Claims

1. A data transmission method in a Long Term Evolution, LTE, system based on unequal error protection performed by a base station, the method comprising:

    • determining a segment quantity $C'$ according to a formula $C' = \dfrac{Q_m}{2} * \left\lceil \dfrac{B}{(Z-L)*Q_m/2} \right\rceil$, wherein Z represents a maximum value of a code block size, B represents a magnitude of an input bit stream corresponding to the code block, L represents a magnitude of cyclic redundancy check, CRC, parity bits and $Q_m$ is a number of symbol bits in a constellation diagram (step 301),
    • segmenting the code block according to the segment quantity $C'$ (step 302),
    • turbo encoding the segmented code blocks to obtain encoded code blocks (step 303),
    • performing interleaving processing separately on the encoded code blocks by using an interleaver, to obtain interleaved encoded code blocks (step 304),
    • performing rate matching on the interleaved encoded code blocks to obtain output code blocks (step 305),
    • using every $Q_m/2$ output code blocks as a code block group, and sorting the output code blocks in each code block group according to importance of the data in each output code block (step 306),
    • for each code block group: separately obtaining one bit from each sorted output code block of the code block group and cascading the obtained bits, and repeating this operation until $Q_m$ bits are cascaded, thereby obtaining cascaded code blocks (step 307),
    • sending all cascaded code blocks to a terminal device (step 310).

2. A base station in a Long Term Evolution, LTE, system, wherein the base station is configured to perform the method according to claim 1.

## Patentansprüche

1. Datenübertragungsverfahren in einem Long Term Evolution-(LTE)-System auf der Basis von ungleichem Fehlerschutz, der von einer Basisstation vorgenommen wird, wobei das Verfahren umfasst:

    • Bestimmen einer Segmentmenge $C'$ gemäß einer Formel

$$C' = \frac{Q_m}{2} * \left\lceil \frac{B}{(Z-L)*Q_m/2} \right\rceil ,$$

wobei Z einen Maximalwert einer Code-Blockgröße repräsentiert, B repräsentiert eine Größe eines Eingangsbitstroms, der dem Codeblock entspricht, L repräsentiert eine Größe einer zyklischen Redundanzprüfung, CRC, Paritätsbits, und $Q_m$ ist eine Anzahl von Symbolbits in einem Konstellationsdiagramm (Schritt 301),
• Segmentieren des Codeblocks entsprechend der Segmentgröße $C'$ (Schritt 302),
• Turbo-Codierung der segmentierten Codeblöcke, um codierte Codeblöcke zu erhalten (Schritt 303),
• Ausführen der Verschachtelungsverarbeitung getrennt an den codierten Codeblöcken durch Verwendung eines Verschachtelers, um verschachtelte codierte Codeblöcke zu erhalten (Schritt 304),
• Ausführen der Ratenanpassung an den verschachtelten codierten Codeblöcken, um ausgegebene Codeblöcke zu erhalten (Schritt 305),
• Verwenden aller $Q_m/2$ ausgegebenen Codeblöcke als Codeblockgruppe und Sortieren der ausgegebenen Codeblöcke in jeder Codeblockgruppe entsprechend der Bedeutung der Daten in jedem ausgegebenen Codeblock (Schritt 306),
• für jede Codeblockgruppe: separates Gewinnen von einem Bit von jedem sortierten ausgegebenen Codeblock der Codeblockgruppe und Kaskadieren der gewonnenen Bits, und
Wiederholen dieser Operation, bis $Q_m$ Bits kaskadiert sind, dadurch Erhalten von kaskadierten Codeblöcken (Schritt 307),
• Senden aller kaskadierten Codeblöcke an ein Endgerät (Schritt 310).

2. Basisstation in einem Long Term Evolution-(LTE)-System, wobei die Basisstation dafür ausgelegt ist, das Verfahren nach Anspruch 1 auszuführen.

**Revendications**

1. Procédé de transmission de données dans un système d'évolution à long terme (LTE) basé sur une protection inégale contre les erreurs réalisée par une station de base, le procédé consistant :

• à déterminer une quantité de segments $C'$ en fonction d'une formule $C' = \frac{Q_m}{2} * \left\lceil \frac{B}{(Z-L)*Q_m/2} \right\rceil$, dans lequel

Z représente une valeur maximale d'une taille de bloc de code, B représente une grandeur d'un train de bits d'entrée correspondant au bloc de code, L représente une grandeur de bits de parité de contrôle de redondance cyclique (CRC) et $Q_m$ est un nombre de bits de symbole dans un diagramme de constellation (étape 301),
• à segmenter le bloc de code en fonction de la quantité de segments $C'$ (étape 302),
• à effectuer un turbocodage sur les blocs de code segmentés pour obtenir des blocs de code codés (étape 303),
• à réaliser un traitement d'entrelacement de manière distincte sur les blocs de code codés en utilisant un entrelaceur, pour obtenir des blocs de code codés entrelacés (étape 304),
• à réaliser une mise en correspondance de taux sur les blocs de code codés entrelacés pour obtenir des blocs de code de sortie (étape 305),
• à utiliser tous les $Q_m/2$ blocs de code de sortie comme groupe de blocs de code et à trier les blocs de code de sortie dans chaque groupe de blocs de code en fonction de l'importance des données dans chaque bloc de code de sortie (étape 306),
• pour chaque groupe de blocs de code : à obtenir de manière distincte un bit de chaque bloc de code de sortie trié du groupe de blocs de code et à mettre en cascade les bits obtenus, et à répéter cette opération jusqu'à ce que $Q_m$ bits soient mis en cascade, ce qui permet d'obtenir des blocs de code mis en cascade (étape 307),
• à envoyer tous les blocs de code mis en cascade à un dispositif de terminal (étape 310).

2. Station de base dans un système d'évolution à long terme (LTE), dans laquelle la station de base est configurée pour réaliser le procédé selon la revendication 1.

FIG. 1

| Segment, according to a quantity of symbol bits in a constellation diagram, a code block corresponding to data, to obtain segmented code blocks | 201 |

| Perform rate matching on the segmented code blocks obtained by channel encoding, to obtain output code blocks | 202 |

| Cascade the output code blocks according to the quantity of symbol bits in the constellation diagram, to obtain cascaded code blocks | 203 |

| Send the cascaded code blocks to a terminal device | 204 |

FIG. 2

Determine a segment quantity according to a quantity $Q_m$ of symbol bits in a constellation diagram, where the segment quantity is an integer multiple of $Q_m/2$ —— 301

Segment a code block according to the segment quantity —— 302

Encode the segmented code blocks to obtain encoded code blocks —— 303

Perform interleaving processing on the encoded code blocks by using an interleaver, to obtain interleaved code blocks —— 304

Perform rate matching on the interleaved code blocks to obtain output code blocks —— 305

Use every $Q_m/2$ output code blocks as a code block group, and sort the output code blocks in each code block group according to importance of data —— 306

Separately obtain one bit from each sorted output code block corresponding to each code block group and cascade the obtained bits, and repeat this operation until $Q_m$ bits are cascaded —— 307

Perform data modulation on cascaded code blocks to obtain modulated data —— 308

Perform digital-to-analog conversion on the modulated data to obtain analog data —— 309

Send the analog data to a terminal device —— 310

FIG. 3

FIG. 4

FIG. 5

FIG. 6

Receive cascaded code blocks sent by a base station, where the cascaded code blocks are obtained after a code block corresponding to data is segmented according to a quantity of symbol bits in a constellation diagram, rate matching is performed on the segmented code blocks obtained by channel encoding to obtain output code blocks, and the output code blocks are cascaded according to the quantity of symbol bits in the constellation diagram

~ 701

Perform code block splitting on the cascaded code blocks according to the quantity of symbol bits in the constellation diagram, to obtain split code blocks

~ 702

Perform code block cascading on the split code blocks obtained by channel decoding, to obtain the data

~ 703

FIG. 7

Receive cascaded code blocks sent by a base station, where the cascaded code blocks are obtained after a code block corresponding to data is segmented according to a quantity of symbol bits in a constellation diagram, rate matching is performed on the segmented code blocks obtained by channel encoding to obtain output code blocks, and the output code blocks are cascaded according to the quantity of symbol bits in the constellation diagram — 801

Use every $Q_m/2$ bits in the cascaded code blocks as a bit group, sequentially obtain one bit from each bit group, and form a bit stream by using the obtained bits — 802

Perform de-interleaving processing on a split code blocks by using a de-interleaver, to obtain de-interleaved code blocks — 803

Perform decoding processing on the de-interleaved code blocks to obtain decoded code blocks — 804

Sequentially perform CRC check and code block cascading processing on the decoded code blocks, to obtain the data — 805

FIG. 8

Segment, according to a preset parameter, a code block corresponding to data, to obtain segmented code blocks ~ 901

Perform encoding processing on the segmented code blocks to obtain encoded code blocks, where the encoded code blocks include system bit code blocks ~ 902

Perform interleaving processing on the system bit code blocks according to a quantity of symbol bits in a constellation diagram, to obtain interleaved code blocks ~ 903

Cascade the interleaved code blocks to obtain cascaded code blocks, and send the cascaded code blocks to a terminal device ~ 904

FIG. 9

Determine a segment quantity, a length of a segmented code block, and a quantity of first padding bits according to a preset parameter, where the padding bit is a bit used when bit padding is performed on a code block ~ 1001

Perform bit padding on the code block according to the segment quantity, the length of a segmented code block, and the quantity of first padding bits ~ 1002

Perform encoding processing on a segmented code blocks to obtain encoded code blocks, where the encoded code blocks include system bit code blocks ~ 1003

Determine a quantity of rows of an interleaver according to a quantity of symbol bits in a constellation diagram, and determine a quantity of second padding bits according to the quantity of rows of the interleaver and a preset quantity of columns of the interleaver ~ 1004

Separately place the padding bit and an information bit according to the quantity of second padding bits and the quantity of symbol bits in the constellation diagram, where the information bit is a bit corresponding to data ~ 1005

Cascade interleaved code blocks to obtain cascaded code blocks, and send the cascaded code blocks to a terminal device ~ 1006

FIG. 10

MAC PDU

FIG. 11

An input sequence is $d_0^{(0)}d_1^{(0)}...d_{(D-1)}^{(0)}$

$C_{subblock}^{TC} = 32$

An output sequence is $v_0^{(0)}v_1^{(0)}...v_{(T-1)}^{(0)}$

FIG. 12

Receive cascaded code blocks sent by a base station, where the
cascaded code blocks are obtained after a code block corresponding
to data is segmented according to a quantity of symbol bits in a
constellation diagram, rate matching is performed on the segmented
code blocks obtained by channel encoding to obtain output code
blocks, and the output code blocks are cascaded according to the
quantity of symbol bits in the constellation diagram

~ 1301

Perform LTE data receiving processing on the cascaded code blocks
to obtain check code blocks

~ 1302

Perform column-in-row-out code block cascading on the check code
blocks to obtain cascaded code blocks

~ 1303

FIG. 13

| Segmentation module | Matching module | Cascading module | Sending module |

11       12       13       14

FIG. 14

Segmentation module

Determining unit — 111

Segmentation unit — 112

Matching module 12

Cascading module 13

Sending module 14

11

FIG. 15

FIG. 16

FIG. 17

FIG. 18

EP 3 306 844 B1

Segmentation module

First determining unit 211

Padding unit 212

21

Encoding module 22

Interleaving module

Second determining unit 231

Placing unit 232

23

Cascading module 24

Sending module 25

FIG. 19

FIG. 20

FIG. 21

FIG. 22

Cascading module

Splitting unit — 421

De-interleaving unit — 422

Decoding unit — 423

Check unit — 424

Receiving module
41

Cascading module
43

42

FIG. 23

Processor

Transmitter

51

52

FIG. 24

Processor

Transmitter

61

62

FIG. 25

| Receiver | Processor |
|----------|-----------|

71            72

FIG. 26

| Receiver | Processor |
|----------|-----------|

81            82

FIG. 27

**EP 3 306 844 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1189380 A2